# FASCICULE DE BREVET EUROPEEN

(11) **EP 1 266 409 B1**
(45) Date de publication et mention de la délivrance du brevet: **08.09.2010**
(21) Numéro de dépôt: 01919535.3
(22) Date de dépôt: 21.03.2001
(51) Int. Cl.: H01L 29/786, H01L 21/336

(54) **TRANSISTOR MOS A SOURCE ET DRAIN METALLIQUES, ET PROCEDE DE FABRICATION D'UN TEL TRANSISTOR**
MOS-TRANSISTOR MIT METALLISCHEN SOURCE- UND DRAINGEBIETEN UND DESSEN HERSTELLUNGSVERFAHREN
MOS TRANSISTOR WITH METAL SOURCE AND DRAIN, AND METHOD FOR MANUFACTURING THE SAME

(30) Priorité: 22.03.2000 FR 0003634
(43) Date de publication de la demande: 18.12.2002
(73) Titulaire: Commissariat à l'Énergie Atomique et aux Énergies Alternatives, 75015 Paris (FR)
(72) Inventeur: DELEONIBUS, Simon, La Chanteraie, 38640 Claix (FR)
(74) Mandataire: Ilgart, Jean-Christophe
(86) Numéro de dépôt international: PCT/FR2001/000841
(87) Numéro de publication internationale: WO 2001/071818

(56) Documents cités:
- EP-A- 0 480 635
- EP-A- 0 603 102
- FR-A- 2 749 977
- US-A- 5 132 755
- US-A- 5 532 175
- US-A- 5 698 869
- US-A- 5 864 161
- SWIRHUN ET AL.: "A VLSI-Suitable Schottky-Barrier CMOS process" IEEE TRANSACTIONS ON ELECTRON DEVICES, vol. ED-32, no. 2, February 1985 (1985-02) , pages 194-202, USA

## Description

### Domaine technique

La présente invention concerne un transistor de type MOS (Metal-Oxyde-Semi-conducteur) à source et à drain métalliques, et à des procédés de fabrication d'un tel transistor.

Elle trouve des applications dans les domaines de la micro-électronique notamment pour la fabrication de circuits intégrés, à transistors complémentaires ou non.

De façon particulière, l'invention vise des applications requérant une forte intégration des composants, une faible consommation en énergie ou une fréquence de fonctionnement élevée.

### Etat de la technique antérieure

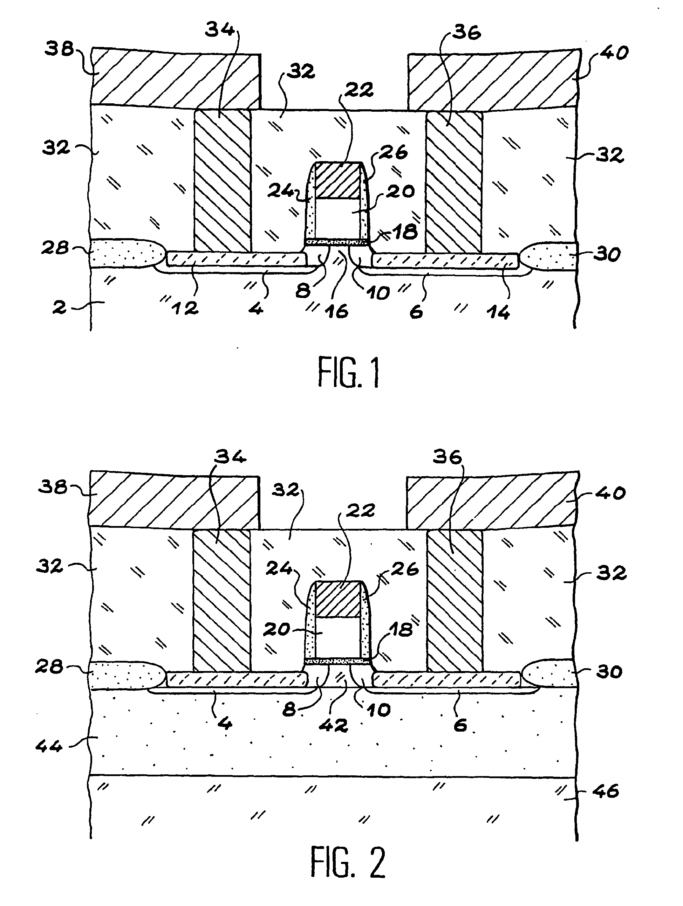

La figure 1 est une vue en coupe transversale schématique d'un transistor MOS classique, en fin d'un procédé d'intégration de ce transistor. Le procédé de fabrication est le même pour les transistors à canal n et les transistors à canal p hormis les étapes de dopage.

Le transistor de la figure 1 comprend un substrat 2 en silicium de type p si le transistor est à canal n.

Sur ce substrat 2 sont formés deux zones 4 et 6 espacées l'une de l'autre.

Ces zones 4 et 6 sont des zones diffusées de type n⁺ formant la source et le drain du transistor.

Comme on le voit sur la figure 1, les zones 4 et 6 sont respectivement prolongées par des zones 8 et 10 qui sont des zones diffusées de type n- (moins dopées que les zones 4 et 6).

Les zones 8 et 10 constituent des extensions des zones de source et de drain sous la grille du transistor dont il sera question par la suite.

Le transistor de la figure 1 comprend aussi deux zones 12 et 14 qui s'étendent respectivement au-dessus des zones 4 et 6 et sensiblement au même niveau que les zones 8 et 10 (qui sont en face l'une de l'autre et seulement séparées l'une de l'autre par un faible intervalle de silicium de type p).

Ces zones 12 et 14 sont faites d'un siliciure métallique et sont auto-alignées par rapport à la grille du transistor et par rapport aux zones d'isolation de champ de ce transistor, dont il sera question par la suite.

Les zones 12 et 14 constituent les métallisations-shunts de la source et du drain du transistor.

Au-dessus de la zone 16 en silicium de type p qui sépare les zones 8 et 10 l'une de l'autre, se trouve une couche électriquement isolante 18 en silice qui s'étend également au-dessus de ces zones 8 et 10 et qui constitue l'isolant de grille du transistor.

Au-dessus de la couche 18 se trouve une couche 20 de silicium polycristallin.

Au-dessus de cette couche 20 se trouve une couche 22 qui est faite d'un siliciure métallique et constitue une métallisation-shunt.

La grille du transistor est formée par ces couches 20 et 22.

De plus, deux espaceurs électriquement isolants 24 et 26, par exemple en silice ou en nitrure de silicium, s'étendent de part et d'autre de l'empilement constitué par les couches 20 et 22, jusqu'à l'isolant de grille 18.

Le transistor représenté sur la figure 1 est électriquement isolé d'autres transistors identiques (non représentés), également formés sur le substrat 2, grâce à des zones d'isolation de champ 28 et 30 de type LOCOS.

L'ensemble de la structure ainsi obtenue est recouvert par une couche 32 isolante, en verre de silice dopé au phosphore et au bore.

Deux ouvertures traversent de part en part cette couche 32 et débouchent respectivement sur les zones 12 et 14.

Ces deux ouvertures sont remplies d'un métal par dépôt chimique en phase vapeur et constituent respectivement des contacts de source et de drain 34 et 36.

Le transistor de la figure 1 comprend aussi deux couches métalliques d'interconnexion 38 et 40 qui se trouvent à la surface de la couche 32 et prolongent respectivement les contacts 34 et 36.

Le contact de grille n'est pas représenté sur la figure 1.

La figure 2 est une vue en coupe transversale schématique d'un autre transistor MOS classique.

Il s'agit d'un transistor MOS sur SOI (silicium sur isolant) qui est représenté à la fin de son procédé d'intégration.

Le transistor de la figure 2 diffère de celui de la figure 1 par le fait que les couches 4 et 6 y sont beaucoup plus minces et que ces couches 4, 6 et la zone 42 en silicium, comprise entre ces dernières, reposent sur une couche 44 d'oxyde de silicium enterrée qui repose elle-même sur un substrat de silicium 46.

Les transistors MOS décrits ci-dessus présentent un certain nombre de limitations liées à leur caractéristiques électroniques et à leur encombrement sur le substrat.

L'une des principales limitations est constituée par la valeur de résistance d'accès au canal. Celle-ci est essentiellement due à la résistance propre des régions de source et de drain, de même qu'à la qualité des contacts source-canal et drain-canal.

La résistance d'accès au canal des transistors constitue une contrainte qui influe négativement, notamment sur les performances de vitesse de fonctionnement et de consommation des circuits qui en sont équipés.

La résistance d'accès peut être diminuée en augmentant la concentration de dopage des régions de source et de drain. Cependant, une trop forte concentration peut conduire à des phénomènes de perçage électrique et peut nuire à la longévité des transistors.

La résistance d'accès peut également être réduite en augmentant l'épaisseur du canal et des régions de source et de drain. Dans ce cas également une difficulté apparaît dans le sens qu'une plus grande épaisseur de ces régions peut provoquer un perçage du transistor et des courants de fuite entre source et drain. Une épaisseur plus importante des régions de source et de drain conduit aussi à l'augmentation des capacités parasites source/substrat et drain/substrat.

Une faible profondeur du canal et des régions de source et de drain autorise une meilleure tenue du transistor mais engendre une résistance d'accès plus élevée.

Par ailleurs, la réalisation de contacts, tels que les contacts 34 et 36, visibles sur les figures 1 et 2, est tributaire de la précision d'alignement des outils de fabrication utilisés. Cette contrainte nuit à l'intégration forte des transistors et à la réduction de leur taille.

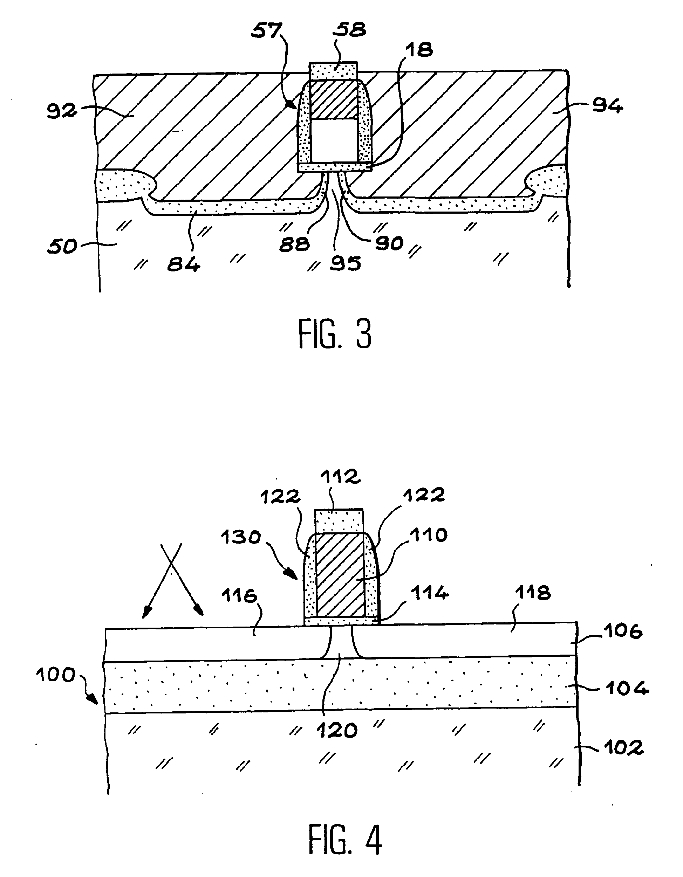

La figure 3 montre un autre type de transistors MOS connus.

Ce type de transistor comprend une structure de grille 57 comparable à celle des figures 1 et 2 déjà décrites. Celle-ci surmonte un canal très fin 95 défini dans un substrat 50.

De part et d'autre de la structure de grille on observe une source et un drain métalliques 92, 94. Les source et drain sont auto-alignés sur la structure de grille 57 et viennent s'étendre en partie sous celle-ci. La référence 58 désigne une couche d'arrêt de gravure ou de polissage qui sépare la source du drain.

La source et le drain sont par ailleurs séparés du substrat 50 par une couche isolante 84. Des extensions 88 et 90 de la couche isolante viennent rejoindre la couche d'isolant de grille et séparent respectivement les source et drain 92, 94 de la région de canal 95.

Les extensions 88 et 90 sont suffisamment minces pour permettre le passage de porteurs de charges, par effet tunnel, de la source au drain, à travers le canal afin d'y favoriser le phénomène de blocage de Coulomb.

Le caractère métallique des source et drain, de même que leur extension partielle sous la structure de grille, tendent à réduire la résistance d'accès, comparativement aux transistors des figures 1 et 2.

De plus, l'auto-alignement des source et drain sur la structure de grille améliore la compacité du transistor et favorise sa miniaturisation.

Une description plus détaillée d'un transistor conforme à la figure 3 peut être trouvée dans le document (1) dont les références sont précisées à la fin de la description. Le document (3) décrit in autre type de transistors MOS connus, à barrière Schottky, comprenant également des régions source et drain métalliques. D'autres documents illustratifs d'un art antérieur ou des technologies de fabrication mises en oeuvre sont également référencés à la fin de la description.

### Exposé de l'invention

L'invention a pour but de proposer un transistor MOS qui présente des performances améliorées par rapport aux transistors décrits précédemment, et qui ne fasse pas appel à une conduction par effet tunnel.

Un autre but est de proposer un tel transistor particulièrement compact et susceptible d'une forte intégration dans le cadre de la réalisation de circuits.

Un autre but encore est de proposer un tel transistor qui ait une résistance d'accès particulièrement faible et qui soit particulièrement résistant aux phénomènes de percement ou de fuites électriques.

L'invention a également pour but de proposer des procédés de réalisation d'un tel transistor.

Pour atteindre les buts ci-dessus, l'invention a plus précisément pour objet un transistor MOS comprenant :
- une région de canal en un matériau semi-conducteur surmontée par une structure de grille, la structure de grille comprenant une grille et des espaceurs isolants tapissant les flancs de la grille,
- des régions, dites régions d'extension de source et de drain, situées respectivement de part et d'autre du canal, en contact direct avec le matériau semi-conducteur du canal, et disposées pour l'essentiel sous la structure de grille, les régions d'extension étant en siliciure métallique.
- des régions de source et de drain, en métal, respectivement en contact avec les régions d'extension de source et de drain et s'étendant en partie sous la structure de grille.

Par ailleurs, les régions d'extension de source et de drain s'étendent de préférence au moins en partie sous la grille, de façon à optimiser le fonctionnement du transistor.

Le transistor de l'invention se distingue donc fondamentalement du transistor de la figure 3 et ne fait pas appel à l'effet tunnel.

Le transistor de l'invention fonctionne comme un dispositif à canal d'inversion de surface ou enterré alors que le dispositif de la figure 3 est un dispositif MOS à puits quantique utilisant l'effet de blocage de Coulomb dans tout le volume semi-conducteur sous la grille.

Le transistor de l'invention peut être utilisé comme un dispositif amplificateur de tension.

Le dispositif de la figure 3 peut être utilisé comme un dispositif mémoire ou analogique de comptage des électrons.

Le transistor peut comporter par ailleurs une couche d'isolant, prévue pour l'isoler électriquement d'une partie massive d'un substrat de support sur lequel il est réalisé. Ceci est le cas notamment lorsque le transistor est réalisé sur un substrat de type SOI (Silicon On Insulator, silicium sur isolant) dans lequel une couche enterrée d'oxyde de silicium constitue la couche isolante.

La couche isolante permet en particulier d'éviter des courants parasites vers la partie massive du substrat, et permet de mieux isoler électriquement les régions de source et de drain. Elle limite égarement leur épaisseur.

Selon une autre possibilité, le transistor peut comprendre une couche d'isolant discontinue, séparant l'ensemble constitué par les régions de source et de drain et les régions d'extension de source et de drain, d'une partie massive du substrat. Dans ce cas, le canal peut rester en contact électrique avec ladite partie massive. L'ouverture vers le substrat massif sous-jacent permet alors d'évacuer les courants parasites engendrés sous la grille à l'interface avec le drain

L'invention a également pour objet un procédé de fabrication sur un substrat d'un transistor MOS comprenant :
- une région de canal en un matériau semi-conducteur, surmontée par une structure de grille, la structure de grille comprenant une grille et des espaceurs isolants tapissant des flancs de la grille,
- des régions, dites régions d'extension de source et de drain, en siliciure métallique, situées respectivement de part et d'autre du canal, en contact direct avec le matériau semi-conducteur du canal et s'étendant pour l'essentiel sous la structure de grille,
- des régions de source et de drain, en métal, respectivement en contact avec les régions d'extension de source et de drain.

Le procédé comporte au moins une étape de gravure du substrat pour définir la région de canal, la gravure s'étendant en partie sous la structure de grille.

Selon une possibilité de mise en oeuvre du procédé de l'invention, le procédé peut comprendre .
- la formation sur un substrat d'une structure de grille comprenant une grille et des espaceurs latéraux isolants, tapissant la grille,
- la gravure d'une partie du substrat de part et d'autre de la structure grille, et partiellement sous la structure de grille, en préservant sous la grille une région du substrat formant la région de canal,
- la mise en place de matériau sur des flancs opposés de la région de canal pour former respectivement les régions d'extension de source et de drain,
- la formation des source et drain, comprenant le dépôt d'un métal en contact avec les régions d'extension de source et de drain.

On entend par mise en place d'un matériau sur les flancs du canal aussi bien une croissance de matériau, telle qu'une épitaxie par exemple, qu'un simple dépôt de matériau. La formation des régions d'extension peut comporter, outre la mise en place de matériau, un traitement thermique. Ces aspect sera décrit plus en détail dans la suite du texte.

Selon la possibilité de mise en oeuvre du procédé indiquée ci-dessus, la gravure ne fixe pas les dimensions des régions d'extension de source et de drain mais fixe simplement la largeur du canal dans la direction source-drain.

Ainsi, seul le canal est réalisé dans le matériau semi-conducteur du substrat qui porte le transistor. Les régions d'extension, formées postérieurement à la gravure, par croissance, peuvent donc être en un matériau différent, choisi librement.

Selon l'invention, on réalise les régions d'extension de source et de drain par formation sur les flancs du canal de régions de siliciure de métal. Les régions de siliciure, qui constituent les régions d'extension de source et de drain, sont formées, par exemple, par dépôt d'un métal puis par un traitement thermique pour provoquer l'interdiffusion du métal avec le silicium du canal.

On peut graver le substrat de façon sélective. Dans ce cas, on effectue avant la gravure une implantation d'impuretés dans le substrat de façon à doper une couche du substrat s'étendant de part et d'autre de la structure de grille et s'étendant partiellement sous la structure de grille. On ne préserve ainsi du dopage qu'une région destinée à former la région de canal. L'implantation est suivie par une gravure sélective pour éliminer la couche ainsi dopée du substrat.

D'autres caractéristiques et avantages de l'invention ressortiront mieux de la description qui va suivre, en référence aux figures des dessins annexés. Cette description est donnée à titre purement illustratif et non limitatif.

### Brève description des figures

- La figure 1, déjà décrite, est une coupe transversale schématique d'un transistor MOS, de type connu, formé sur un substrat semi-conducteur massif.
- La figure 2, déjà décrite, est une coupe transversale schématique d'un transistor MOS comparable à celui de la figure 1, formé sur un substrat de type silicium sur isolant (SOI).
- La figure 3, déjà décrite, est une coupe transversale schématique d'un autre transistor MOS de type connu, à source et drain métalliques.
- Les figures 4 à 8 sont des coupes transversales schématiques d'un substrat de type SOI sur lequel on réalise un transistor ne faisant pas partie de l'invention. Elles illustrent des étapes successives d'un procédé de fabrication du transistor.
- Les figures 9 à 13 sont des coupes transversales schématiques d'un substrat de type SOI sur lequel on réalise un transistor ne faisant pas partie de l'invention. Elles illustrent des étapes successives

d'un procédé de fabrication du transistor constituant une variante du procédé des figures 4 à 8.

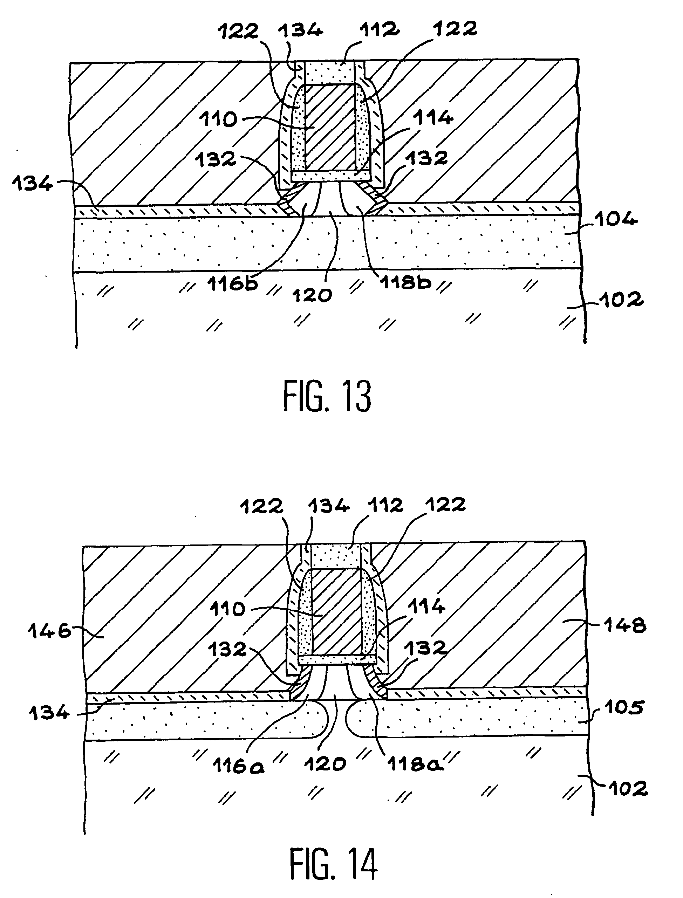

- La figure 14 est une coupe transversale
   schématique d'un transistor ne faisant pas partie de l'invention réalisé sur un substrat semi-conducteur massif.

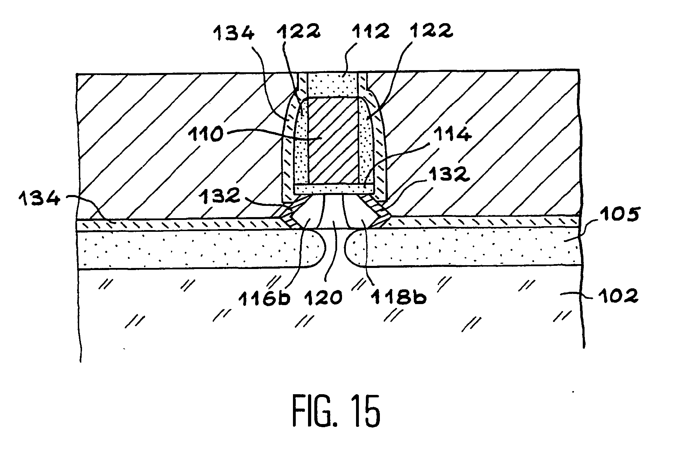

- La figure 15 est une coupe transversale schématique d'un transistor, ne faisant pas partie de l'invention, réalisé sur un substrat semi-conducteur massif et constituant une variante par rapport au transistor de la figure 14.

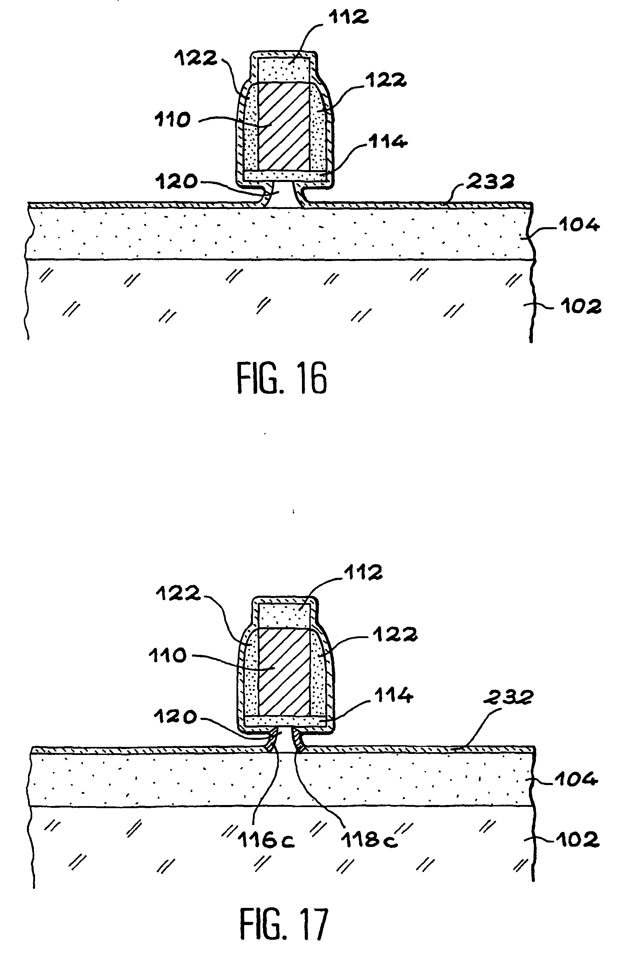

- Les figures 16 à 18 sont des coupes transversales schématiques un procédé de réalisation d'un transistor conforme à l'invention, sur un substrat de type silicium sur isolant.

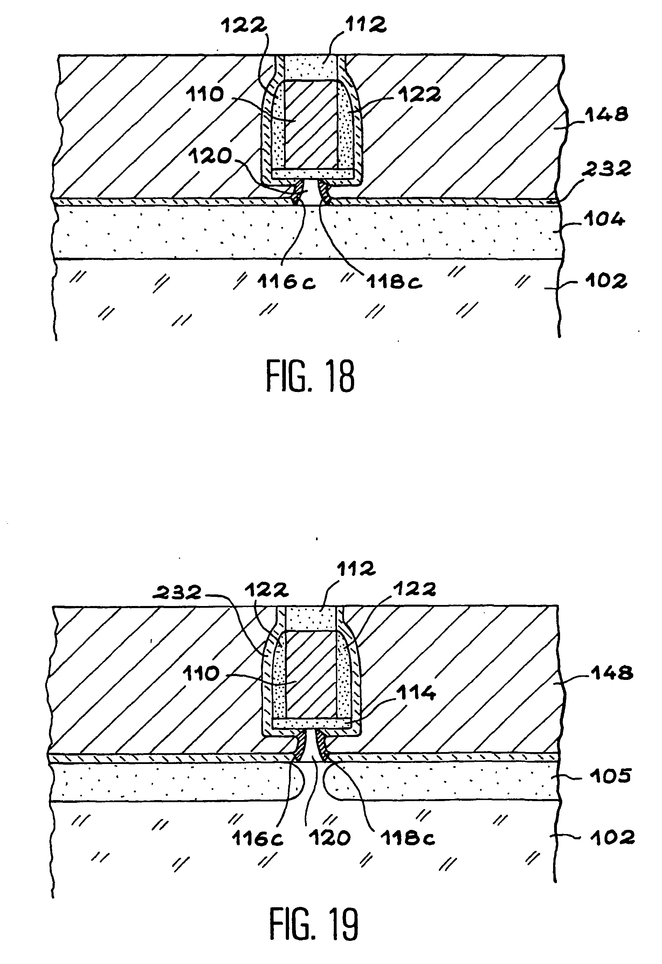

- La figure 19 est une coupe transversale schématique illustrant la fabrication du transistor de la figure 18 sur un substrat massif.

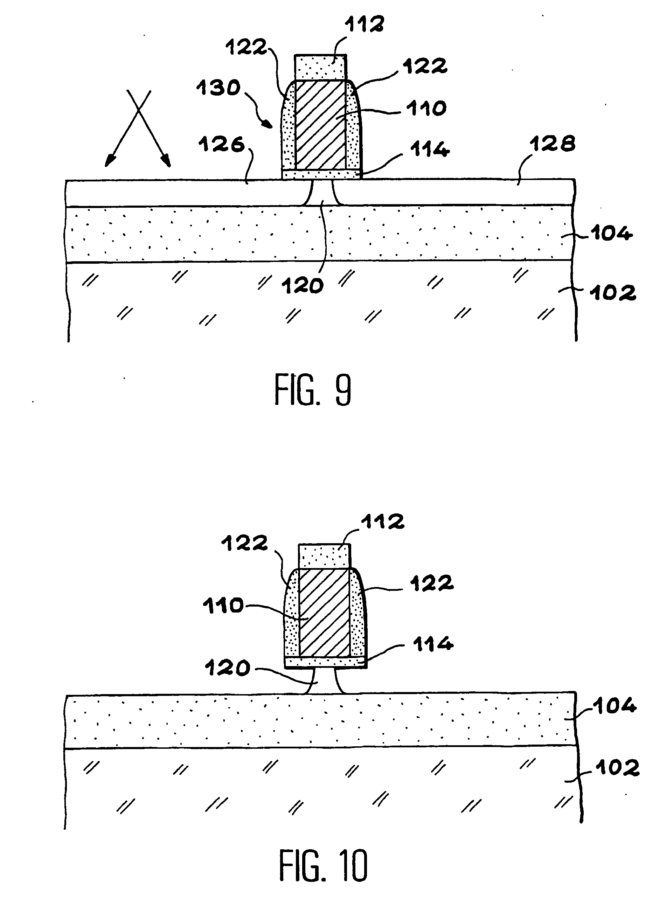

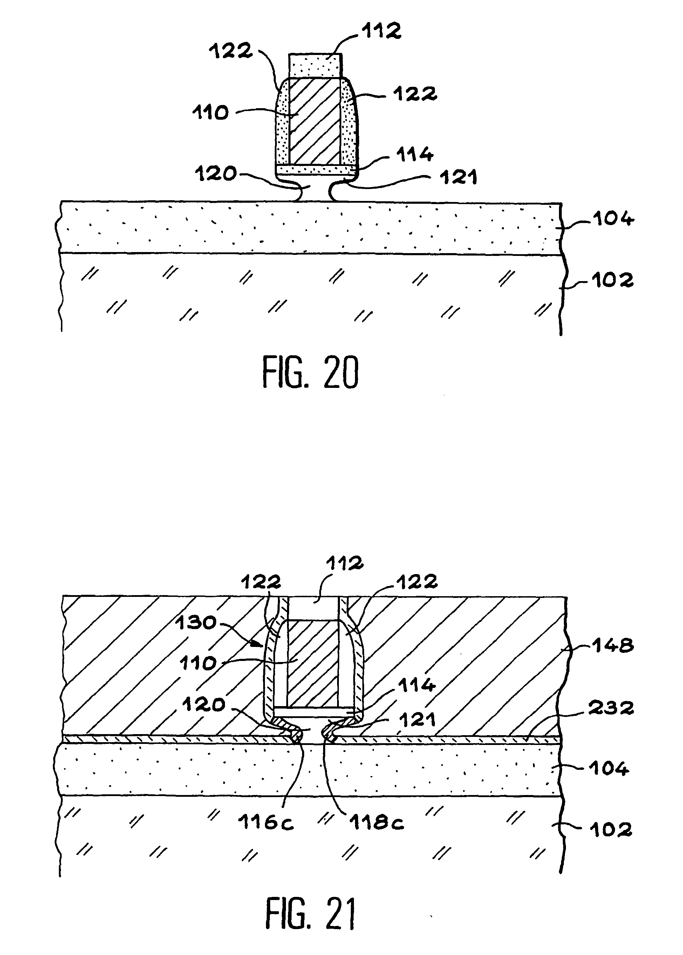

- La figure 20 est une coupe schématique illustrant une opération de gravure sous la grille lors d'une étape de fabrication d'un transistor conforme à l'invention, constituant une variante par rapport à la figure 10.

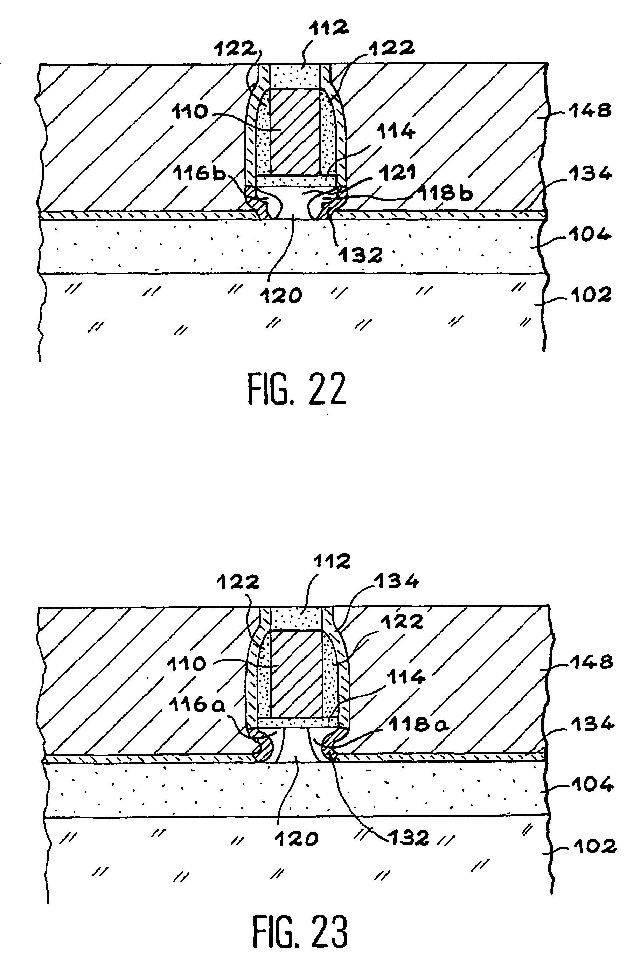

- Les figures 21 et 22 montrent en coupe schématique deux possibilités de réalisation d'un transistor à partir de la structure de la figure 20, dont celle illustrée dans la figure 21 est conforme à l'invention.
- La figure 23 montre en coupe schématique une autre possibilité encore de réalisation d'un transistor ne faisant pas partie de l'invention, dans lequel des régions d'extension de source et de drain sont définies par gravure.

### Description détaillée d'exemples et de modes de mise en oeuvre de l'invention

Dans la description qui suit, des parties identiques, similaires ou équivalentes apparaissant sur différentes figures sont repérées avec les mêmes références. Ces références sont toutefois sans lien avec celles des figures 1 à 3 déjà décrites dans la partie introductive.

Dans une première partie, on décrira et illustrera la fabrication d'un transistor MOS sur un substrat de type SOI. Les étapes de fabrication sont cependant sensiblement les mêmes sur un substrat massif en un semi-conducteur quelconque.

Le substrat 100 SOI comprend, comme le montre la figure 4, une partie massive 102 de silicium, une couche enterrée et isolante 104 d'oxyde de silicium, et une couche superficielle 106 de silicium.

La couche superficielle 106 est une couche mince, présentant une épaisseur comprise entre 5 et 1000 mm, par exemple.

Une première étape du procédé comprend la formation sur la couche mince superficielle 106 d'une grille 110 de transistor. Celle-ci peut être métallique ou, dans le cas de l'exemple décrit, en silicium polycristallin, par exemple. Au sommet de la grille 110, on trouve une couche 112 en un matériau isolant électrique tel que du nitrure de silicium. Le rôle de cette couche apparaîtra ultérieurement dans la description. Enfin, on observe sous la grille une couche 114 d'isolant de grille, par exemple en oxyde de silicium.

La fabrication de la grille a lieu selon des procédés de lithographie bien connus dans le domaine de la micro-électronique et n'est donc pas précisée ici.

Une première implantation d'impuretés dopantes utilisant la grille comme masque d'implantation permet de former de part et d'autre de la grille des régions dopées 116, 118. Celles-ci délimitent sous la grille une région de canal 120. Les régions dopées sont elles-mêmes formées dans la couche superficielle 106 et sont délimitées par la couche enterrée 104. Les termes "de part et d'autre de la grille" sont compris en référence à un côté de la grille tourné vers la source et un côté de la grille tourné vers le drain. De plus, l'homme du métier comprendra que les éléments formés de part et d'autre de la grille sont mutuellement isolés entre eux.

Le choix des matériaux dopants utilisés pour former les régions dopées 116, 118 conditionne le type de conductivité des régions d'extension de source et de drain. Ces régions sont mises en forme ultérieurement.

De façon générale, pour un transistor à canal n, on implante des impuretés conduisant à la formation de régions de type n. Pour un transistor à canal p, on forme des régions de type p.

La concentration d'impuretés des régions dopées 116, 118 est supérieure de préférence à celle de la région de canal 120.

Le dopage du canal peut avoir lieu en utilisant soit initialement un substrat dopé soit en effectuant un dopage préliminaire avant la formation de la grille.

La concentration d'impuretés du canal est par exemple de 10¹⁵ à 5.10¹⁸ at/cm³ et celle des régions implantées 116, 118 de l'ordre de 10¹⁸ à 10²⁰ at/cm³.

La concentration en impuretés dopantes des régions 116, 118 peut être uniforme, ou graduelle en augmentant avec la distance par rapport à la région de canal.

On observe également sur la figure que les interfaces des régions dopées 116, 118 avec le canal 120, ne coïncident pas exactement à l'aplomb de la grille mais se situent légèrement sous la grille. Ce décalage peut être provoqué par une diffusion des impuretés dopantes ou en effectuant, comme le montrent des flèches, une implantation qui n'est pas perpendiculaire à la surface du substrat.

Après l'implantation, des espaceurs latéraux isolants 122 sont formés sur les flancs de la grille. Leur formation comprend par exemple le dépôt d'un matériau isolant tel que de l'oxyde ou du nitrure de silicium, suivi d'une gravure anisotrope de ce matériau. Les espaceurs peuvent être simples ou doubles (à deux couches).

L'ensemble formé par la grille 110 et les espaceurs 122 est désigné ci-après par "structure de grille" et porte la référence 130. Eventuellement, avant d'équiper la grille des espaceurs isolants, celle-ci peut subir une oxydation superficielle pour consolider l'isolant de grille (oxyde) et le rendre moins sensible à des traitements thermiques ou chimiques accompagnant les étapes opératoires qui suivent.

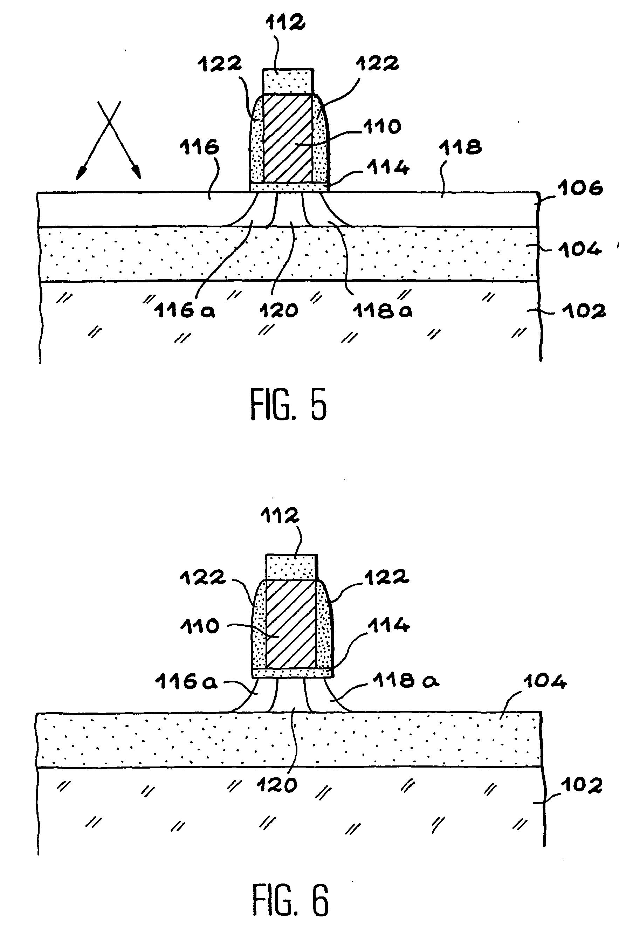

La figure 5 montre une deuxième implantation d'impuretés dans la couche mince superficielle 106 du substrat en utilisant l'ensemble de la structure de grille 130 comme masque d'implantation. Le masque d'implantation est donc plus large que celui utilisé précédemment.

Tout comme la première implantation, la deuxième implantation est exécutée de préférence avec une énergie et une dose suffisantes pour atteindre la couche superficielle sur toute son épaisseur.

La deuxième implantation permet de former dans la couche mince des deuxièmes régions dopées 126, 128 qui s'étendent partiellement sous la structure de grille, en l'occurrence sous les espaceurs 122. Là encore, comme le montrent symboliquement des flèches, l'implantation peut avoir lieu avec un léger angle (par rapport à la normale au substrat).

Les parties des premières régions dopées 116, 118 non atteintes par le deuxième dopage sont respectivement repérées avec les références 116a et 118a.

L'implantation est par exemple une implantation de bore à forte dose de 10¹⁴ à 10¹⁶ at/cm² pour former des régions 126, 128 de type p⁺. Elle peut être remplacée ou renforcée par une implantation de germanium ou de carbone pour former des régions 126, 128 de type SiGe ou SiC. L'implantation est, de façon classique, suivie d'un recuit.

Le type de dopants mis en oeuvre lors de la seconde implantation n'est pas lié à celui de la première implantation.

Le but de la deuxième implantation est essentiellement d'obtenir un matériau susceptible d'être gravé sélectivement par rapport aux régions dopés 116a, 118a non atteintes par la deuxième implantation.

La figure 6 montre le résultat d'une gravure chimique isotrope sélective mise en oeuvre pour éliminer les deuxièmes régions implantées 126, 128. La gravure est sélective par rapport à la couche enterrée 104 de SiO₂, par rapport à l'isolant de grille et les espaceurs (SiO₂ ou Si₃N₄) et par rapport aux régions dopées 116a, 118a préservées de l'implantation.

Pour ces régions il s'agit, par exemple, d'une sélectivité de gravure de Si(p⁺) par rapport à Si(n) ou Si(p), ou d'une sélectivité de gravure de SiGe, SiC par rapport à Si.

Les régions dopées 116a, 118a, qui ne sont dopées qu'une seule fois, constituent les régions d'extension de source et de drain et sont ainsi désignées dans la suite du texte.

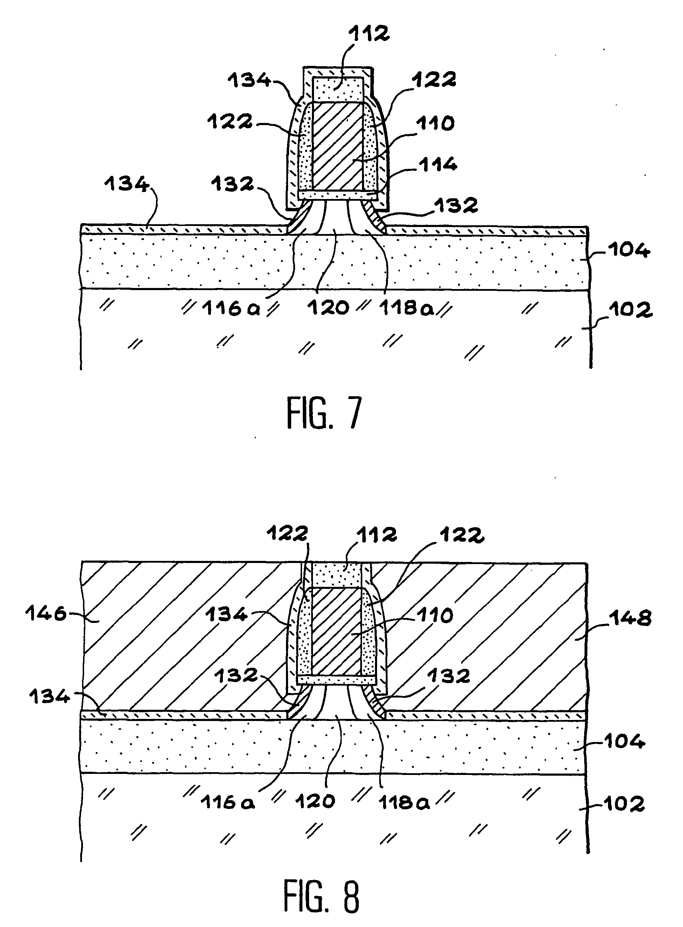

La figure 7 montre la formation d'une couche de contact 132 en siliciure de métal sur les flancs libres des régions d'extension de source et de drain. Elle montre également la formation d'une couche d'accrochage 134, métallique, sur le restant de la structure, c'est-à-dire sur la structure de grille et sur la couche enterrée 104 d'oxyde de silicium, mise à nu par la gravure. A titre d'exemple, les couches de contact et d'accrochage peuvent être respectivement en siliciure de titane TiSi₂ et en nitrure de titane TiN.

La couche métallique d'accrochage peut être entièrement ou partiellement nitrurée pour éviter son oxydation. Elle est déposée de préférence sous atmosphère d'azote.

Les couches d'accrochage 134 et de contact 132 peuvent être formées par un dépôt de métal suivi par un recuit.

La figure 8 montre la formation d'une source 146 et d'un drain 148 en un métal tel que le tungstène (W).

Le métal est déposé selon une technique de dépôt chimique conforme en phase vapeur (CVD) puis est plané pour le rendre affleurant au sommet de la structure de grille.

Le planage, opéré par exemple par un polissage mécano-chimique, est arrêté sur la couche isolante 112 (utilisée comme couche d'arrêt).

Il peut être suivi éventuellement d'une opération de gravure, non visible dans le plan des figures, pour séparer et mettre en forme le métal des régions de source et de drain en dehors de la zone comportant le transistor.

Dans la zone du transistor, les régions de source et de drain sont séparées et isolées par la structure de grille, par le canal 120 et par la couche isolante 112.

On peut observer sur la figure 8 que le métal des source et drain est en contact avec les régions d'extension de source et de drain par l'intermédiaire des couches de contact 132 et s'étend donc partiellement sous la structure de grille.

Une telle construction permet de réduire considérablement la résistance d'accès au canal. La résistance d'un matériau dépend notamment du nombre de porteurs (électrons) présents par unité de volume. Même très dopés, les semi-conducteurs présentent un nombre d'électrons de conduction inférieur à 10²¹cm³, alors qu'il est supérieur à 10²²cm⁻³ pour les métaux.

En outre, pour ce transistor, aucun isolant ne sépare les régions d'extension de source et de drain du métal des source et drain.

Les figures 9 à 13 décrites ci-après illustrent une autre possibilité de réalisation d'un transistor ne faisant pas partie de l'invention. Des étapes opératoires permettant de former des parties identiques à celles des figures précédentes, ne sont pas décrites de façon détaillée. On pourra se reporter au texte qui précède.

Comme le montre la figure 9, une implantation d'impuretés, signifiée par des flèches, est réalisée en utilisant la structure de grille 130 comme masque. Cette implantation n'est pas prévue pour contrôler l'état de dopage d'éventuelles régions d'extension de source ou de drain. De façon comparable à la deuxième implantation décrite en référence à la figure 5, l'implantation d'impuretés est ici une implantation à forte dose permettant de définir des régions dopées sensibles à une gravure sélective. Le dopage effectué est par exemple un dopage au germanium, ou au carbone, ou au bore, il peut être suivi d'un traitement thermique.

Par analogie avec la figure 5, les régions dopées sont repérées avec les références 126, 128.

Une implantation selon un angle, avec rotation du substrat, permet de former des régions 126, 128 qui s'étendent en partie sous la structure de grille, voire sous la grille 122 elle-même.

Une région mince de la couche superficielle 106 du substrat, située sous la grille, est préservée de l'implantation et sépare les régions dopées 126, 128. Il s'agit de la région de canal 120.

La figure 10 montre le résultat d'une gravure sélective des régions dopées. La gravure du matériau dopé Si(p⁺), SiGe ou SiC est sélective par rapport au matériau semi-conducteur du canal, faiblement dopé n ou p (voire intrinsèque). Elle est également sélective par rapport à l'oxyde de silicium de la couche enterrée et par rapport aux matériaux enveloppant la grille.

On observe que la structure de grille n'est maintenue que par la seule région de canal 120 dont les flancs latéraux sont mis à nu par la gravure.

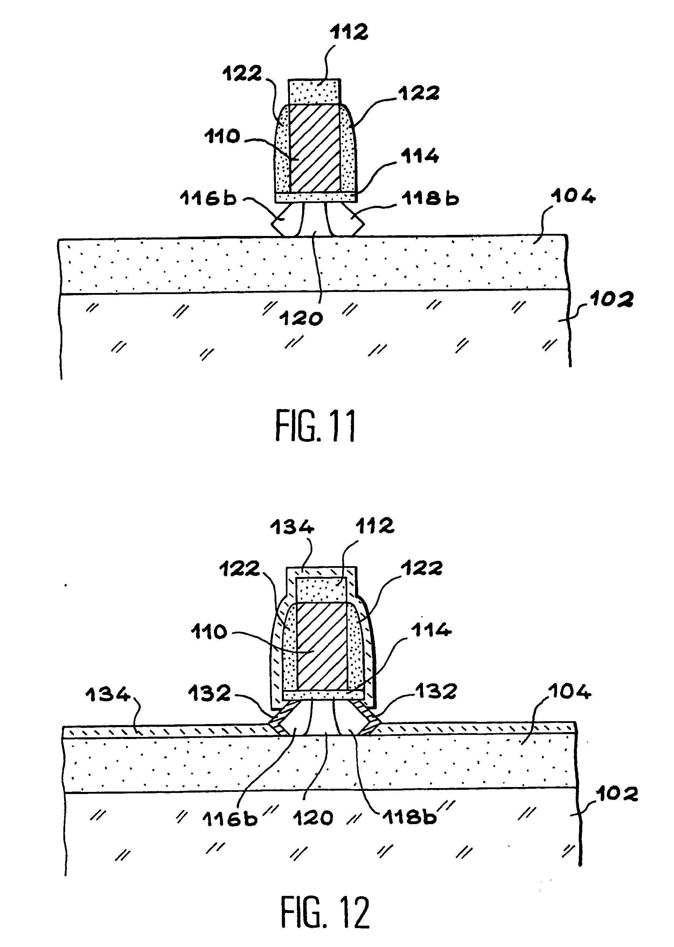

La figure 11 montre la formation des régions d'extension de source et de drain sur le canal. Celles-ci sont formées par une croissance sélective telle qu'une épitaxie par exemple.

Le matériau utilisé peut être un métal, un semi-conducteur ou un composé tel que SiGeₓC_{y} par exemple.

Le choix du matériau est effectué de façon à garantir la croissance sélective et établir un contact redresseur avec le matériau du canal (contact Schottky).

Dans l'exemple illustré, le matériau de la couche enterrée 104, le matériau de l'isolant de grille 114 et le matériau des espaceurs latéraux 122 est de l'oxyde de silicium. Ainsi, une épitaxie de silicium permet naturellement de faire croître les régions d'extension 116b, 118b de façon sélective sur le canal (en silicium).

Lorsque le canal est préalablement dopé, de type p, on fait préférentiellement croître du silicium de type n⁺. Sur un canal de type n on fait préférentiellement croître du silicium de type p⁺.

Lorsque le matériau utilisé pour les régions d'extension de source et de drain est du métal, on peut utiliser, par exemple, du platine ou de l'oxyde de ruthénium ou de l'iridium, lorsque le canal est du type n (transistor MOS à canal p), et du niobium, de l'aluminium, du molybdène ou du titane lorsque le canal est du type p (transistor MOS à canal n).

La formation de facettes sur les régions d'extension de source et de drain est un phénomène lié à la croissance du matériau.

La figure 12 montre la formation d'une couche de contact (siliciure de métal) 132 sur les régions d'extension de source et de drain et la formation d'une couche d'accrochage métallique sur la structure de grille et les parties affleurantes de la couche enterrée 104. La couche de contact peut être du type MSi₂ ou M/MSi₂ où M désigne un métal tel que le titane, le cobalt ou le nickel.

La figure 13 montre la formation des régions de source et de drain 146, 148 par dépôt, planage et gravure d'un métal. On peut se reporter à ce sujet à la description relative à la figure 8.

Lorsque les régions d'extension de source et de drain 116b, 118b sont en un métal, le métal des source et drain peut être déposé directement contre ces régions sans former au préalable une couche de siliciure. Il est cependant possible de prévoir un métal d'accrochage supplémentaire.

La description des figures qui précède concerne plus particulièrement des transistors MOS réalisés sur des substrats de type silicium sur isolant (SOI). Les transistors peuvent cependant être réalisés également sur un substrat massif tel qu'un substrat de silicium ou autres semi-conducteurs III-V à condition d'utiliser une technique de report de couche mince (SMART-CUT, par exemple).

Les figures 14 et 15 montrent respectivement des transistors obtenus selon les procédés décrits précédemment sur un substrat massif de silicium. On peut donc se référer à la description qui précède.

On observe qu'une couche d'oxyde de silicium 105 est située sous les source et drain et s'étend sensiblement jusque sous le canal 120.

Contrairement à la couche enterrée d'oxyde de silicium 104, visible sur les figures précédentes, la couche d'oxyde 105 ne préexiste pas à la formation du transistor.

La couche d'oxyde 105 peut être formée par une oxydation sélective enterrée; on peut se reporter à ce sujet à la description du document (1) déjà évoqué.

Lors de l'obtention de la couche d'oxyde par oxydation, la structure de grille peut servir de masque d'implantation. Dans ce cas, qui est illustré par les figures, la région de canal 120 n'est pas séparée de la partie massive du substrat et est protégée par une couche de nitrure de silicium. Une telle structure permet l'évacuation des charges parasites engendrées près de l'interface isolant de grille/drain.

En l'absence de la couche d'oxyde enterrée, lors de la gravure, la profondeur de la gravure peut être contrôlée en agissant sur la profondeur d'implantation d'impuretés dopantes lors de la définition des zones dopées devant être sélectivement éliminées.

Sur la figure 14, une forme d'arrondi des flancs des régions d'extension de source et de drain 116a, 118a montre que ces régions ont été définies par une gravure sélective et isotrope, c'est-à-dire selon la première possibilité de mise en oeuvre du procédé de l'invention.

Sur la figure 15, en revanche, les facettes des régions d'extension de source et de drain 116b, 118b sont le signe d'une formation par croissance sélective.

On décrit à présent, en référence aux figures 16, 17 et 18 un procédé de réalisation d'un transistor conforme à l'invention. Selon ce procédé, les régions d'extension de source et de drain sont formées par des zones de siliciure formées directement sur les flancs du canal.

Les premières étapes du procédé sont sensiblement les mêmes que celles qui permettent d'obtenir la structure déjà décrite en référence aux figures 9 et 10. Ces étapes ne sont par conséquent pas reprises ici. Comme le montre la figure 16, on dépose une couche de métal 232 qui recouvre les flancs de la région de canal, préalablement mise à nu par la gravure. La couche de métal 232 recouvre aussi la structure de grille 130 et la couche d'oxyde enterrée 104, également mise à nu par la gravure.

Le métal est choisi pour permettre une siliciuration sélective avec le silicium de la région de canal 120, afin de former des régions d'extension de source et de drain siliciurées. De plus, le métal est choisi pour former des régions d'extension constituant des contacts redresseurs Schottky.

A titre d'exemple, pour des transistors PMOS, avec un canal de type p, le métal peut être choisi parmi le platine, l'iridium ou l'oxyde de ruthénium.

Pour des transistors NMOS, avec un canal de type n, le métal peut être choisi parmi le niobium, l'aluminium, le titane, l'erbium par exemple.

La figure 17 montre une étape de siliciuration sélective lors de laquelle on soumet la structure à un traitement thermique avec un budget thermique suffisant pour provoquer l'interdiffusion partielle du métal déposé avec le silicium du canal 120.

Ce traitement thermique permet d'obtenir des régions d'extension de source et de drain 116c, 118c sous la forme de zones siliciurées qui s'étendent en partie dans la région de canal telle que définie initialement par gravure.

On observe en outre que les régions d'extension de source et de drain 116c, 118c s'étendent, tout au moins en partie, sous la grille 110.

La partie de la couche de métal 232 s'étendant en dehors des flancs de la zone de canal ne subit pas de siliciuration dans la mesure où elle n'est pas en contact avec au silicium. Dans ces régions, selon le métal choisi, celui-ci peut soit rester inchangé au cours du traitement thermique, soit subir, par exemple, une nitruration. Ceci est le cas, par exemple, lorsque le métal est du titane et que le traitement thermique a lieu sous atmosphère d'azote.

Le titane, en contact de l'atmosphère d'azote subit une nitruration superficielle. La nitruration a lieu aussi bien en dehors de la partie de la couche de titane qui recouvre les flancs de canal, que sur cette partie.

La partie du métal nitrurée, ou de façon plus générale la partie du métal qui ne participe pas à la siliciuration, c'est-à-dire à la formation des régions d'extension de source et de drain, peut constituer une couche d'accrochage pour les régions de source et de drain réalisées ultérieurement.

Par ailleurs, une autre couche d'accrochage, supplémentaire, peut être formée sur la structure après le traitement thermique. Une telle couche n'est pas représentée sur la figure pour des raisons de simplification.

La figure 18 montre la formation de la source et du drain 146, 148 par dépôt et planage d'un métal. On peut se reporter à ce sujet à la description qui précède, relative aux figures 8 et 13, par exemple.

Le planage a lieu avec arrêt sur la couche isolante 112 de sorte que la partie de la couche de métal 232 au-dessus de cette couche isolante est éliminée. Ceci permet d'isoler électriquement la source et le drain.

La réalisation de régions d'extension de source et de drain sous la forme de zones siliciurées n'est pas limitée au cas où le transistor est fabriqué sur un substrat de type silicium sur isolant. Elle peut également être envisagée pour un transistor fabriqué sur un substrat massif.

La figure 19 illustre une telle réalisation. On observe que les régions d'extension de source et de drain 116c, 118c sont également situées en partie sous la grille 120. De plus, un passage existe entre le canal 120, subsistant entre les régions 116c, 118c, et la partie massive du substrat 102. Le passage s'étend entre deux parties de la couche d'oxyde 105 situées respectivement sous les source et drain. Pour les autres éléments de la figure on peut se reporter à la description qui précède.

Comme indiqué dans la description qui précède, la gravure de la couche mince superficielle ou la gravure de la partie du substrat dans laquelle est formée le canal du transistor peuvent être avantageusement des gravures sélectives entre des régions présentant différentes concentrations de dopage. La partie de matériau devant être gravée est alors définie, par exemple, par une implantation d'impuretés de forte dose. A ce sujet on peut se reporter à la description relative aux figures 5 et 6 ou aux figures 9 et 10.

Dans l'exemple de ces figures, l'implantation est effectuée avec une énergie assez faible de sorte que la concentration d'impuretés est maximale au voisinage de la surface. Il en résulte, comme le montrent les figures 6 et 10 que la couche d'isolant de grille est partiellement mise à nu lors de la gravure sur sa face tournée vers le substrat.

En revanche, lorsque l'implantation est réalisée avec une énergie plus grande, la concentration maximale d'impuretés est située plus en profondeur et il est possible de préserver du matériau semi-conducteur sur une partie plus grande de la face de la couche d'isolant de grille tournée vers le substrat.

On obtient ainsi, après gravure, une structure qui est par exemple celle représentée à la figure 20. En comparant cette structure avec celle de la figure 10, on observe que la région de canal présente désormais une corniche 121 qui s'étend sous l'ensemble de la couche d'isolant de grille.

La figure 21 montre un transistor fabriqué à partir de la structure de la figure 20 et dans lequel les régions d'extension de source et de drain sont formées par siliciuration. Le procédé de siliciuration est le même que celui décrit en référence aux figures 16 et 17.

On observe que les régions d'extension de source et de drain, formées par inter-diffusion partielle du métal de la couche de métal 232 avec le silicium de la région de canal 120, s'étendent sur la partie de corniche qui est siliciurée entièrement ou presque entièrement. Elles s'étendent donc depuis le dessous de la grille 110, jusqu'au bord de la structure de grille 130. Grâce à la forme particulière des régions d'extension de source et de drain qui en résulte, la résistance d'accès au canal est encore améliorée et les performances en fréquence du transistor sont encore meilleures.

La figure 22 montre, à titre d'exemple ne faisant pas partie de l'invention, un autre transistor, toujours fabriqué à partir de la structure de la figure 20 et dans lequel les régions d'extension de source et de drain 116b, 118b sont formées par croissance de matériau. Le procédé de formation des extension par croissance, en tant que tel, est le même que celui décrit en référence à la figure 11. On observe que la région de canal présente toujours une corniche 121 sur laquelle le matériau des régions d'extension de source et de drains croît également.

Les références 132, 134 désignent respectivement une couche de siliciure formée sur les régions d'extension de source et de drain 116b, 118b, et une couche d'accrochage formée sur le reste de la structure. Il convient de préciser cependant que la couche de siliciure 132 de la figure 22 est différente du siliciure formé sur le canal conformément à la figure 21. En effet, sur la figure 22, la couche de siliciure 132 recouvre simplement les régions d'extension de source et de drain 116b, 118b tandis que sur la figure 21 le siliciure constitue les régions d'extension de source et de drain 116c, 118c.

La figure 23 montre encore un autre transistor dans lequel les régions d'extension de source et de drain 116a, 118a sont définies lors de la gravure du substrat conformément au procédé décrit en référence aux figures 5 et 6.

Toutefois, l'implantation des impuretés dopantes, définissant la zone à éliminer lors de la gravure, est comme pour les applications illustrées par les figures 20 à 22, effectuée avec une profondeur suffisante pour préserver une "corniche" 117 sous l'isolant de grille 114.

On peut observer sur la figure 23 que la "corniche" 117 est désormais formée non pas dans la région de canal, mais dans les régions d'extension de source et de drain 116a, 118a.

Les références 132 et 134 désignent toujours une couche de siliciure, formée sur les régions d'extension de source et de drain, et une couche d'accrochage, à l'instar de la structure décrite en référence à la figure 7.

Les procédés de fabrication illustrés par les figures 20 à 23 concernent des transistors réalisés sur un substrat de type silicium sur isolant.

Il est toutefois possible d'adapter ces procédés à des transistors réalisés sur substrat massif. On peut se reporter à ce sujet aux figures précédentes 14, 15 et 19 ainsi qu'à la description qui s'y rapporte.

### DOCUMENTS CITES

*(1)*
   FR-2 749 977 du 9/10/1998
*(2)*
   "Extremely high selective etching of porous Si for single etch-step band-and-etch-back SOI" K. Sakaguchi et al., Extended abstracts of the 1994 International Conference on solid state devices and materials, Yokohawa, 1994, p. 259-261
(3)
   "A VLSI-Suitable Schottky-Barrier CMOS Process" S.E. Swirhun et al., IEEE Transactions on Electron Devices, Vol. ED-32, No.2, 1985, p. 194-202

## Revendications

1. Transistor à effet de champ comprenant :
- une région de canal (120) en un matériau semi-conducteur surmontée par une structure de grille (130), la structure de grille comprenant une grille (110) et des espaceurs isolants (122) tapissant ses flancs,
- des régions, dites régions d'extension de source et de drain (116c 118c), situées respectivement de part et d'autre de la région de canal, en contact direct avec le matériau semi-conducteur de la région de canal, et disposées pour l'essentiel sous la structure de grille, les régions d'extension étant en siliciure métallique,
- des régions de source et de drain (146, 148) en métal, respectivement en contact avec les régions d'extension de source et de drain et s'étendant en partie sous la structure de grille.

2. Transistor selon la revendication 1, comprenant couche d'isolant (104) pour isoler électriquement le transistor d'une partie massive (102) d'un substrat de support (100).

3. Transistor selon la revendication 1 comprenant une couche d'isolant discontinue (105) séparant un ensemble formé par les régions de source et de drain et les régions d'extension de source et de drain, d'une partie massive (102) d'un substrat supportant le transistor, la région de canal (120) étant en contact électrique avec ladite partie massive.

4. Procédé de fabrication sur un substrat d'un transistor à effet de champ comprenant :
- une région de canal (120) en un matériau semi-conducteur, surmontée par une structure de grille (130), la structure de grille comprenant une grille (110) et des espaceurs isolant (122) tapissant des flancs de la grille,
- des régions (116a, 116b), dites régions d'extension de source et de drain en siliciure métallique situées respectivement de part et d'autre de la région de canal, en contact direct avec le matériau semi-conducteur de la région de canal et s'étendant pour l'essentiel sous la structure de grille,
- des régions de source et de drain (146, 148), en métal, respectivement en contact avec les régions d'extension de source et de drain,
le procédé comportant au moins une étape de gravure du substrat pour définir la région de canal (120), la gravure s'étendant partiellement sous la structure de grille.

5. Procédé de fabrication d'un transistor selon la revendication 4, sur un substrat de silicium massif comprenant la formation d'une couche d'oxyde de silicium (105) en surface du substrat après l'étape de gravure, de part et d'autre de la grille, la couche d'oxyde de silicium s'étendant au moins en partie sous les régions d'extension de source et de drain.

6. Procédé selon la revendication 4, comprenant :
- la formation sur un substrat (100) d'une structure de grille (150) comprenant une grille (110) et des espaceurs latéraux isolants (122), tapissant la grille,
- la gravure d'une partie du substrat de part et d'autre de la structure grille, et partiellement sous la structure de grille, en préservant sous la grille une région du substrat formant la région de canal (120),
- la mise en place de matériau sur des flancs opposés de la région de canal pour former respectivement les régions d'extension de source et de drain,
- la formation des source et drain (146, 148), comprenant le dépôt d'un métal en contact avec les régions d'extension de source et de drain.

7. Procédé selon la revendication 6, dans lequel, pour former les régions d'extension de source et de drain, on dépose sur les flancs de la région de canal un métal susceptible d'une siliciuration sélective, et on provoque une interdiffusion partielle du métal avec le matériau de la région de canal.

8. Procédé selon la revendication 6, dans lequel, avant la gravure, on effectue une implantation d'impuretés dans le substrat pour doper une couche du substrat s'étendant de part et d'autre de la structure de grille et s'étendant partiellement sous la structure de grille, de façon à ne préserver du dopage qu'une région destinée à former la région de canal, et dans lequel on effectue une gravure sélective pour éliminer la couche ainsi dopée du substrat.

## Claims

1. Field effect transistor, comprising:
- a channel region (120) made of a semiconducting material above which there is a grid structure (130), the grid structure comprising a grid (110) and insulating spacers (122) coating the sides of the grid;
- regions, called the source and drain extension regions (116c, 118c), located on each side of the channel in direct contact with the semiconducting material of the channel region, and arranged essentially under the grid structure, the extension regions being made of metal silicide,
- metallic source and drain regions (146, 148), in contact with the source and drain extension regions respectively, and extending partly under the grid structure.

2. Transistor according to claim 1, comprising an insulating layer (104) to electrically isolate the transistor from a solid part (102) of a support substrate (100).

3. Transistor according to claim 1, comprising a discontinuous insulation layer (105) separating an assembly formed by the source and drain regions and the source and drain extension regions, a solid part (102) of a substrate supporting the transistor, the channel region (120) being in electrical contact with the said solid part.

4. Manufacturing process of a field effect transistor on a substrate comprising:
- a channel region (120) made of a semiconducting material above which there is a grid structure (130), the grid structure comprising a grid (110) and insulating spacers (122) coating the sides of the grid;
- regions (116a, 116b), called the source and drain extension regions made of a metal silicide located on each side of the channel region, in direct contact with the semiconducting material of the channel region, and essentially extending under the grid structure,
- metallic source and drain regions (146, 148), in contact with the source and drain extension regions respectively,
the process comprising at least one etching step to define the channel region (120), the etching extending partially under the grid structure.

5. Process for manufacturing a transistor according to claim 4, on a solid silicon substrate comprising the formation of a silicon oxide layer (105) on the surface of the substrate after the etching step, on each side of the grid, the silicon oxide layer extending at least partly under the source and drain extension regions.

6. Process according to claim 4, comprising:
- the formation of a grid structure (150) on a substrate (100), comprising a grid (110) and insulating lateral spacers (122) coating the grid;
- etching of part of the substrate on each side of the grid structure, and partially under the grid structure, preserving a region of the substrate under the grid, forming the channel region (120);
- placement of material on the sides opposite the channel region to form the source and drain extension regions respectively;
- formation of source and drain (146, 148), including the deposition of a metal in contact with the source and drain extension regions.

7. Process according to claim 6, in which the source and drain extension regions are formed by depositing a metal subject to selective silicidation on the sides of the channel, and partial interdiffusion of the metal with the material of the channel is provoked.

8. Process according to claim 6, in which impurities are implanted in the substrate before etching to dope a layer of the substrate extending on each side of the grid structure and extending partially under the grid structure, to preserve only a region in which the channel region will be formed from the doping, and in which selective etching is done to eliminate the layer of the substrate doped in this way.

## Patentansprüche

1. Feldeffekttransistor, umfassend:
- ein Kanalgebiet (120) aus einem Halbleitermaterial, das sich unter einer Gate-Struktur (130) befindet, wobei die Gate-Struktur ein Gate (110) und seine Flanken bedeckende isolierende Spacer (122) umfasst,
- Source- und Drain-Extensionsgebiete genannte Gebiete (116c, 118c) beiderseits des Kanalgebiets mit direktem Kontakt mit dem Halbleitermaterial des Kanalgebiets und im Wesentlichen unter der Gate-Struktur befindlich, wobei die Extensionsgebiete aus metallischem Silicid sind,
- Source- und Draingebiete (146, 148) aus Metall, die sich teils unter die Gate-Struktur erstrecken und jeweils Kontakt haben mit den Source- und Drain-Extensionsgebieten.

2. Transistor nach Anspruch 1, eine Isolierschicht (104) umfassend, um den Transistor elektrisch zu isolieren von einem massiven Teil (102) eines Trägersubstrats (100).

3. Transistor nach Anspruch 1, eine unterbrochene Isolierschicht (105) umfassend, die eine durch die Source- und Draingebiete und die Source- und Drain-Extensionsgebiete gebildete Baugruppe von einem massiven Teil (102) eines den Transistor tragenden Substrats trennen, wobei das Kanalgebiet (120) mit dem genannten massiven Teil elektrisch Kontakt hat.

4. Verfahren zur Herstellung - auf einem Substrat - eines Feldeffekttransistors, umfassend:
- ein Kanalgebiet (120) aus einem Halbleitermaterial, das sich unter einer Gate-Struktur (130) befindet, wobei die Gate-Struktur ein Gate (110) und seine Flanken bedeckende isolierende Spacer (122) umfasst,
- Source- und Drain-Extensionsgebiete genannte Gebiete (116a, 116b) aus metallischem Silicid beiderseits des Kanalgebiets mit direktem Kontakt mit dem Halbleitermaterial des Kanalgebiets und im Wesentlichen unter der Gate-Struktur befindlich,
- Source- und Draingebiete (146, 148) aus Metall, jeweils in Kontakt mit den Source- und
Drain-Extensionsgebieten,
wobei das Verfahren wenigstens einen Schritt zur Ätzung des Substrats umfasst, um das Kanalgebiet (120) zu definieren, und die Ätzung sich partiell unter die Gate-Struktur erstreckt.

5. Verfahren zur Herstellung eines Transistors nach Anspruch 4 auf einem massiven Siliciumsubstrat, die Bildung einer Siliciumdioxidschicht (105) an der Oberfläche des Substrats nach dem Ätzschritt umfassend, beiderseits des Gates, wobei die Siliciumdioxidschicht sich wenigstens teilweise unter die Source- und Drain-Extensionsgebiete erstreckt.

6. Verfahren nach Anspruch 4, umfassend:
- das Bilden einer Gate-Struktur (150) auf einem Substrat (100), die ein Gate (110) und das Gate bedeckende isolierende seitliche Spacer (122) umfasst,
- das Ätzen eines Teils des Substrats beiderseits der Gate-Struktur und partiell unter der Gate-Struktur, wobei unter dem Gate ein Gebiet des Substrats erhalten bleibt, welches das Gate-Gebiet (120) bildet,
- das Aufbringen von Material auf entgegengesetzten Flanken des Kanalgebiets, um jeweils die Source- und Drain-Extensionsgebiete zu bilden,
- das Bilden von Source und Drain (146, 148), umfassend das Abscheiden eines Metalls in Kontakt mit den Source- und Drain-Extensionsgebieten .

7. Verfahren nach Anspruch 6, bei dem man zur Bildung der Source- und Drain-Extensionsgebiete auf den Flanken des Kanalgebiets ein zur selektiven Silicidierung befähigtes Metall abscheidet, und man eine partielle Interdiffusion des Metalls mit dem Material des Kanalgebiets bewirkt.

8. Verfahren nach Anspruch 6, bei dem man vor dem Ätzen Verunreinigungen in das Substrat implantiert, um eine Schicht des Substrats, die sich beiderseits der Gate-Struktur erstreckt und sich partiell unter die Gate-Struktur erstreckt, so zu dotieren, dass nur ein zur Bildung des Kanalgebiets bestimmtes Gebiet nicht dotiert wind, und bei dem man eine selektive Ätzung durchführt, um die so dotierte Schicht des Substrats zu eliminieren.
